# EUROPEAN PATENT APPLICATION

(11) **EP 2 762 768 A1**
(43) Date of publication of application: **06.08.2014**
(21) Application number: 11873050.6
(22) Date of filing: 26.09.2011
(51) Int. Cl.: F21S 8/04, F21S 2/00, F21V 5/04, F21V 7/06, F21V 23/00, F21V 29/00, F21Y 101/02

(54) **LIGHT-EMITTING DEVICE AND LIGHTING APPARATUS**

(71) Applicant: Toshiba Lighting & Technology Corporation, Yokosuka-shi, Kanagawa 237-8510 (JP)
(72) Inventor: INOUE, Masaru, Yokosuka-shi Kanagawa 237-8510 (JP); KAWAGOE, Makoto, Yokosuka-shi Kanagawa 237-8510 (JP); HAYASHI, Junya, Yokosuka-shi Kanagawa 237-8510 (JP); MATSUNO, Masaru, Yokosuka-shi Kanagawa 237-8510 (JP)
(74) Representative: Bokinge, Ole
(86) International application number: PCT/JP2011/071918
(87) International publication number: WO 2013/046305

(57) **Abstract**

A light-emitting device and a luminaire that can reduce glare are provided. A light-emitting device according to an embodiment includes a substrate, an LED chip mounted on the lower surface of the substrate, a light reflecting member arranged downward and on one side when viewed from the LED chip and opened on the other side, a surface of the light reflecting member opposed to the LED chip being a light reflecting surface, and an optical member configured to guide light emitted from the LED chip and reflected by the light reflecting member downward.

## Description

### Technical Field

Embodiments of the present invention relate to a light-emitting device and a luminaire.

### Background Art

In recent years, an LED (light Emitting Diode) chip is used as a light-emitting element of a base light for illuminating the entire room. However, since the LED chip has a small light-emitting area and high brightness compared with an incandescent lamp and a fluorescent tube, a user sometimes feels glare.

### Citation List

### Patent Literature

Patent Literature 1: JP-A-2009-99270

### Summary of Invention

### Technical Problem

It is an object of the present invention to provide a light-emitting device and a luminaire that can reduce glare.

### Solution to Problem

A light-emitting device according to an embodiment includes: a substrate; an LED chip mounted on the lower surface of the substrate; a light reflecting member arranged downward and on one side when viewed from the LED chip and opened on the other side, a surface of the light reflecting member opposed to the LED chip being a light reflecting surface; and an optical member configured to guide light emitted from the LED chip and reflected by the light reflecting member downward.

A luminaire according to an embodiment includes: a light-emitting device; and a chassis configured to cover the upper surface of the light-emitting device. The light-emitting device includes: a substrate; an LED chip mounted on the lower surface of the substrate; and a light reflecting member arranged downward and on one side when viewed from the LED chip and opened on the other side, a surface of the light reflecting member opposed to the LED chip being a light reflecting surface. Heat of the LED chip is transmitted to the chassis by heat conduction.

### Advantageous Effect of Invention

According to the present invention, it is possible to realize a light-emitting device and a luminaire that can reduce glare.

### Brief Description of the Drawings

[Fig. 1] Fig. 1 is a perspective view illustrating a luminaire according to a first embodiment.
[Fig. 2] Fig. 2 is a schematic sectional view illustrating a state in which the luminaire according to the first embodiment is set.
[Fig. 3] Fig. 3 is a plan view illustrating the luminaire according to the first embodiment.
[Fig. 4] Fig. 4 is a sectional view taken along line A-A' shown in Fig. 3.
[Fig. 5] Fig. 5 is a sectional view taken along line B-B' shown in Fig. 3.
[Fig. 6] Fig. 6 is a perspective view illustrating a light-emitting device according to the first embodiment.
[Fig. 7] Fig. 7 is an exploded perspective view illustrating the light-emitting device according to the first embodiment.
[Fig. 8] Figs. 8A to 8C are diagrams illustrating the operation of the luminaire according to the first embodiment.
[Fig. 9] Fig. 9 is a diagram showing a simulation result of a test example of the first embodiment.
[Fig. 10] Fig. 10 is a partially enlarged sectional view illustrating a luminaire according to a first modification of the first embodiment.
[Fig. 11] Fig. 11 is a partially enlarged sectional view illustrating a luminaire according to a second modification of the first embodiment.
[Fig. 12] Figs. 12A and 12B are schematic diagrams illustrating the luminaire attached to the ceiling, wherein Fig. 12A shows the first embodiment and Fig. 12B shows the second modification of the first embodiment.
[Fig. 13] Fig. 13 is a schematic sectional view illustrating a light-emitting device according to a second embodiment.
[Fig. 14] Fig. 14 is a sectional view illustrating a light-emitting device according to a third embodiment.
[Fig. 15] Fig. 15 is a schematic sectional view illustrating a light-emitting device according to a modification of the third embodiment.
[Fig. 16] Fig. 16 is a partial sectional view illustrating a luminaire according to a fourth embodiment.
[Fig. 17] Fig. 17 is a partial sectional view illustrating a luminaire according to a fifth embodiment.
[Fig. 18] Fig. 18 is a perspective view illustrating a luminaire according to a sixth embodiment.
[Fig. 19] Fig. 19 is a schematic plan view illustrating the luminaire according to the sixth embodiment.
[Fig. 20] Fig. 20 is a schematic plan view illustrating a luminaire according to a seventh embodiment.

### Description of Embodiments

A luminaire according to embodiments explained below includes, for example, a light-emitting device and a chassis configured to cover the upper surface of the light-emitting device. The light-emitting device includes a substrate, an LED chip mounted on the lower surface of the substrate, and a light reflecting member arranged downward and on one side when viewed from the LED chip and opened on the other side, a surface of the light reflecting member opposed to the LED chip being a light reflecting surface. Heat of the LED chip is transmitted to the chassis by heat conduction.

Embodiments of the present invention are explained below with reference to the drawings.

First, a first embodiment is explained.

This embodiment is an embodiment of a light-emitting device mounted with an LED chip as a light-emitting element and a luminaire incorporating the light-emitting device.

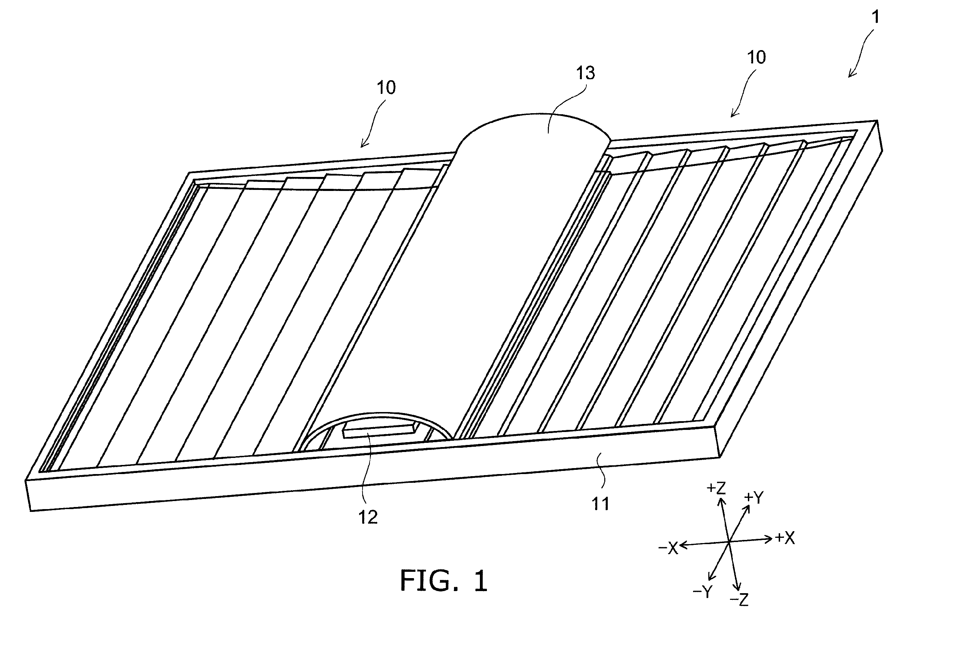

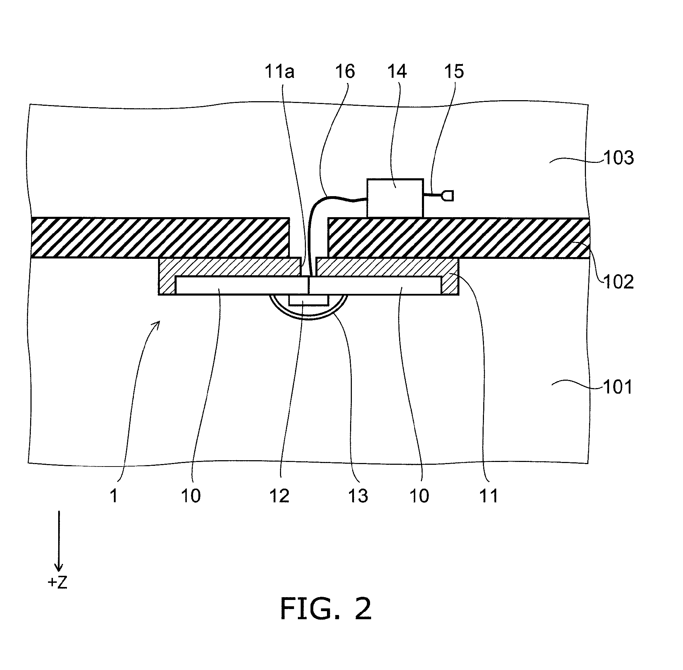

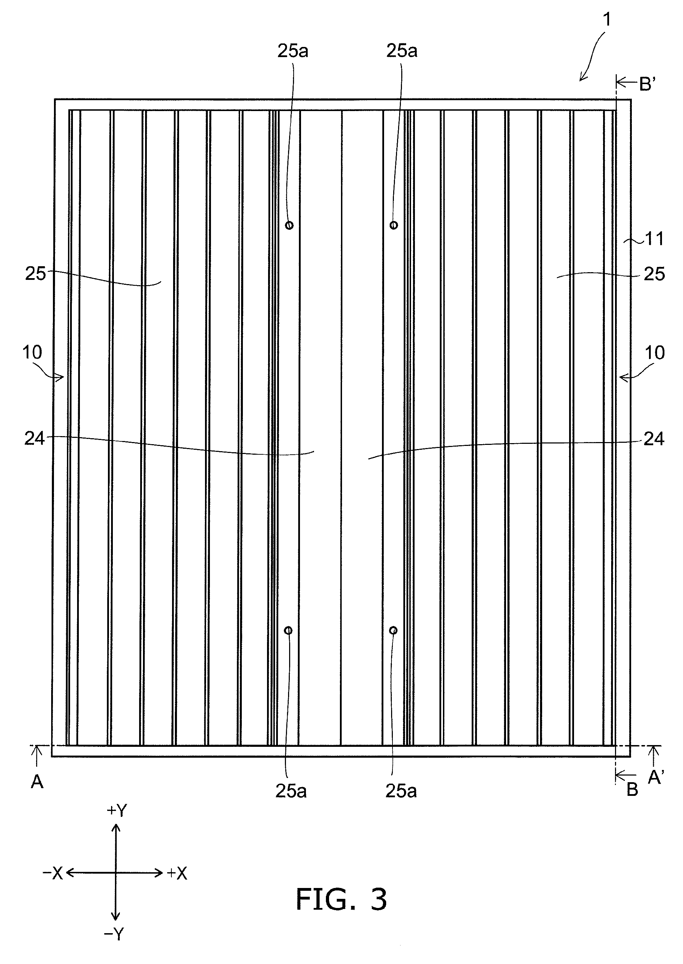

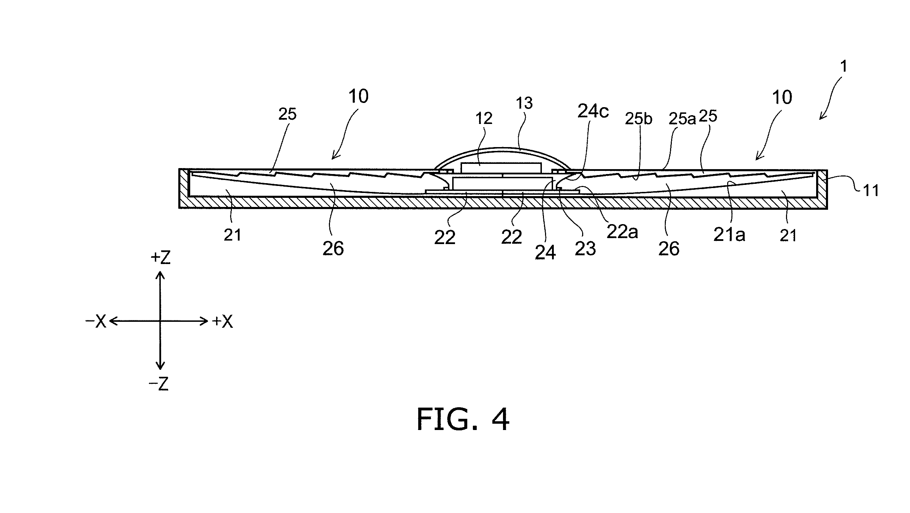

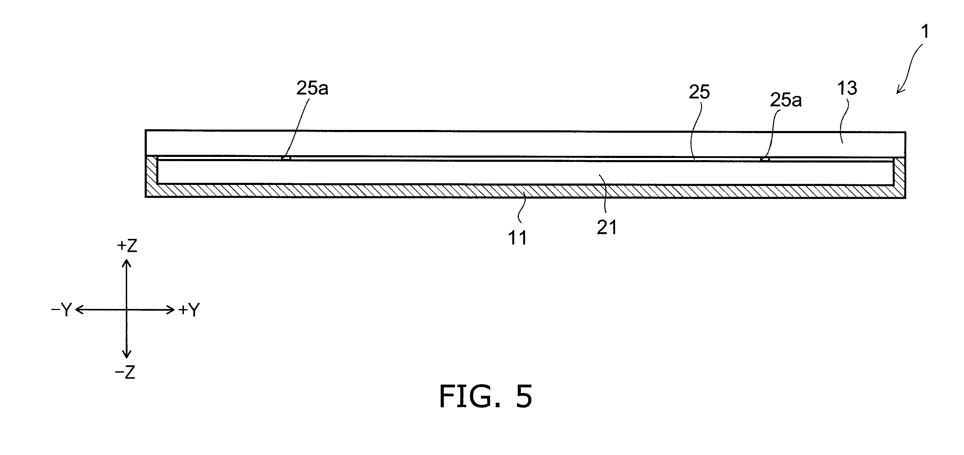

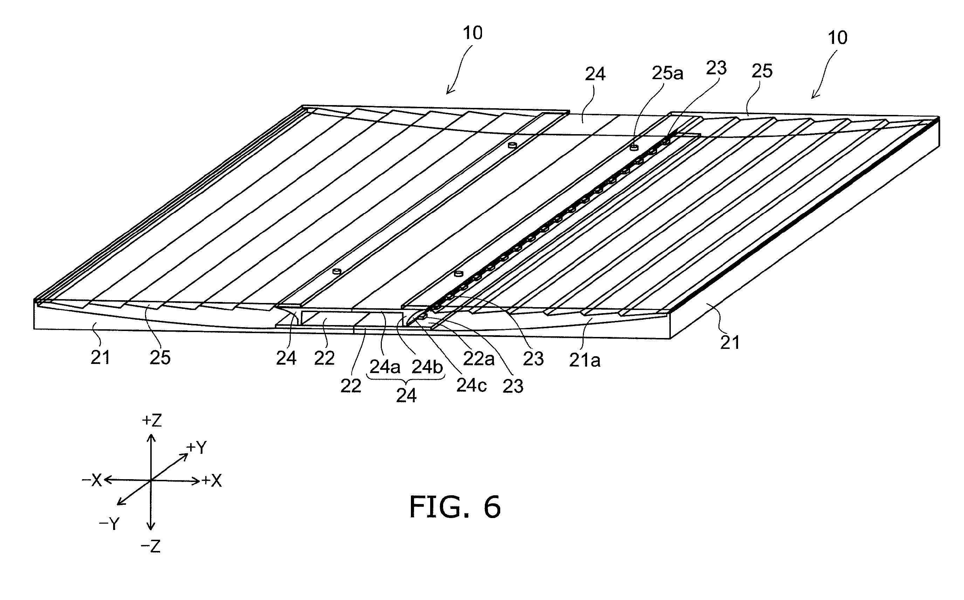

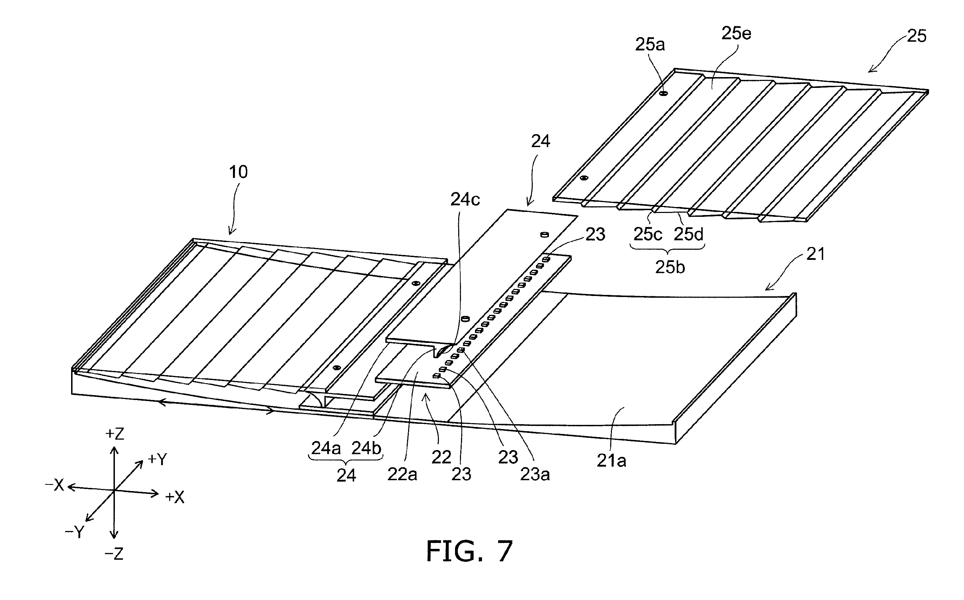

Fig. 1 is a perspective view illustrating the luminaire according to this embodiment. Fig. 2 is a schematic sectional view illustrating a state in which the luminaire according to this embodiment is set. Fig. 3 is a plan view illustrating the luminaire according to this embodiment. Fig. 4 is a sectional view taken along line A-A' shown in Fig. 3. Fig. 5 is a sectional view taken along line B-B' shown in Fig. 3. Fig. 6 is a perspective view illustrating the light-emitting device according to this embodiment. Fig. 7 is an exploded perspective view illustrating the light-emitting device according to this embodiment. For convenience of illustration, in Fig. 3, a control unit and a cover are not shown.

In this specification, for convenience of explanation, an XYZ orthogonal coordinate system is adopted. A "+X direction" and a "-X direction" are directions opposite to each other and collectively referred to as "X direction" as well. The same holds true concerning a "Y direction" and a "Z direction". A "+Z direction" is a direction in which the light-emitting device and the luminaire according to this embodiment as a whole irradiate light. In the figures, to clearly show the figures, the figures are arranged to set the "+Z direction" to the upward direction shown in the figures. However, when the luminaire is attached to the ceiling, the "+Z direction" is the direction of the gravity, i.e., the downward direction. It is assumed that the luminaire according to this embodiment is mainly attached to the ceiling of a room. Therefore, the "+Z direction" is also referred to as "down" and the "-Z direction" is also referred to as "up". However, expressions such as "down" and "up" and the directions shown in the figures do not specify relations with the direction of the gravity.

As shown in Fig. 1, in a luminaire 1 according to this embodiment, a thin rectangular tray-like chassis 11 is provided. The shape of the chassis 11 is a container shape in which a surface in the +Z direction side, which is one of principal planes, is opened and the other five surfaces are configured by rectangular plates. The chassis 11 is formed of metal such as aluminum or resin having a high heat transfer property. The longitudinal direction of the chassis 11 is the Y direction, the width direction of the chassis 11 is the X direction, and the thickness direction of the chassis 11 is the Z direction. In an example, the length in the Y direction in the chassis 11 is about 1200 mm and the length in the X direction in the chassis 11 is about 230 to 240 mm.

Two light-emitting devices 10 are housed on the inside of the chassis 11. The light-emitting devices 10 are arrayed along the X direction. The chassis 11 covers a surface on the -Z direction side of the light-emitting devices 10 and side surfaces other than side surfaces connected to one another. On the +Z direction side viewed from a connecting portion of the light-emitting devices 10, a control unit 12 configured to supply electric power to the light-emitting devices 10 and control the operation of the light-emitting devices 10 is provided. On the +Z direction side viewed from the control unit 12, a cover 13 configured to cover the control unit 12 is provided. The control unit 12 and the cover 13 are arranged between ends of the two light-emitting devices 10 and attached to the light-emitting devices 10.

As shown in Fig. 2, in the luminaire 1, a power supply unit 14 is provided on the outside of the chassis 11. The power supply unit 14 is a primary side power supply to which a 100V commercial alternating current is supplied via a socket 15. The control unit 12 is a secondary side power supply that receives the supply of electric power from the power supply unit 14 and controls the LED chip. The control unit 12 is connected to the power supply unit 14 by a wire 16. For example, the wire 16 is wound around to pass through a hole 11a formed on a surface on the -Z direction side of the chassis 11. When the luminaire 1 is attached to a ceiling 102 of a room 101, the power supply unit 14 is set, for example, in an attic 103.

The configuration of the light-emitting device 10 according to this embodiment is explained.

As shown in Fig. 1, the configurations of the two light-emitting devices 10 configuring the luminaire 1 are the same. The light-emitting devices 10 are arranged to be symmetrical to each other with respect to an YZ plane. The light-emitting device 10 arranged on the +X direction side is explained as an example.

As shown in Figs. 3 to 7, in the light-emitting device 10, a white mirror plate 21 functioning as a light diffusing and reflecting plate, a substrate 22, a plurality of LED chips 23, a mirror surface mirror member 24 functioning as a light reflecting member, and a prism plate 25 are provided. Among these components, the shape of the components excluding the LED chips 23, that is, the white mirror plate 21, the substrate 22, the mirror surface mirror member 24, and the prism plate 25 is a substantially tabular shape, the longitudinal direction, the width direction, and the thickness direction of which are respectively the Y direction, the X direction, and the Z direction. The shapes of XZ sections of the components are the same in the Y direction. The components are explained in detail below.

The white mirror plate 21 is formed of a white material, for example, white resin. The shape of the white mirror plate 21 is a tabular shape, the thickness of which continuously changes along the X direction. A surface on the -Z direction side of the white mirror plate 21 is parallel to an XY plane, configures a surface on the -Z direction side of the light-emitting device 10, and is in contact with the chassis 13. On the other hand, a surface on the +Z direction side (a lower surface) of the white mirror plate 21 is a white surface 21a that diffuses and reflects incident light. An end on the +X direction side of the white mirror plate 21 is located further on the +Z direction side (downward) than an end on the -X direction side of the white mirror plate 21. More specifically, a region excluding an end on the -X direction side in the white surface 21a is an inclined surface displaced further to the +Z direction toward the +X direction and is, for example, a concave curved surface. Therefore, the white mirror plate 21 is the thinnest at the end on the -X direction side, that is, an end connected to the other light-emitting device 10, starts to be thick halfway toward the +X direction, and is the thickest at the end on the +X direction side.

The substrate 22 is arranged at the end on the -X direction side of the white mirror plate 21, that is, on the +Z direction side of a thin plate portion having uniform thickness. The substrate 22 is formed of resin such as glass epoxy resin or metal such as aluminum. The shape of the substrate is a belt shape extending in the Y direction. A printed wire (not shown in the figure) is formed and a white covering layer is formed on a surface on the +Z direction side (a lower surface) of the substrate 22. The surface is a chip mounting surface 22a. A surface on the -Z direction side (an upper surface) of the substrate 22 is in contact with the surface on the +Z direction side (the lower surface) of the white mirror plate 21.

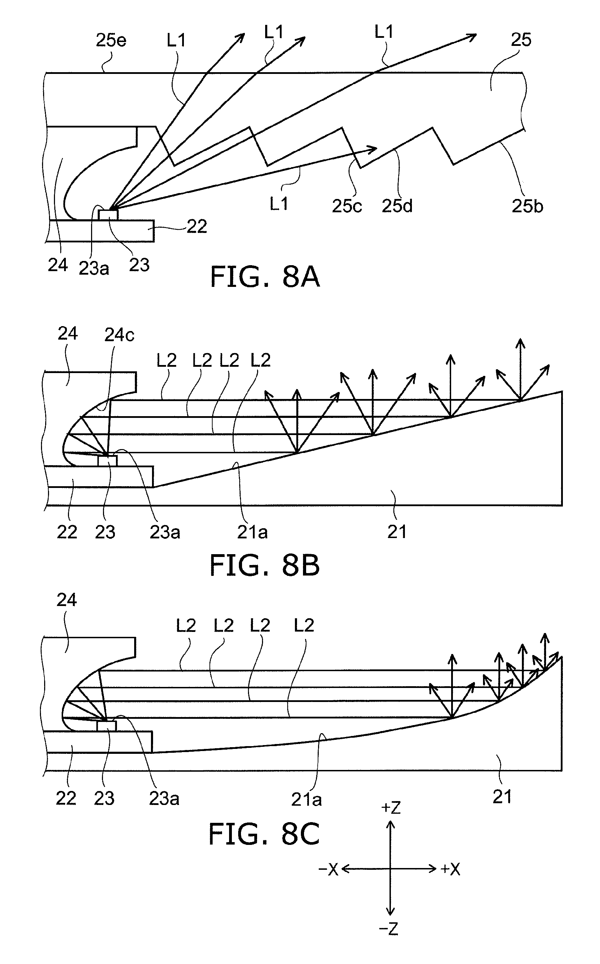

The plurality of LED chips 23 are mounted on the chip mounting surface 22a of the substrate 22. That is, the LED chips 23 are fixed to the substrate 22 and connected to the printed wire (not shown in the figure) of the substrate 22. The LED chip 23 is a chip of a top view type. A light-emitting surface 23a (see Fig. 8A) of the LED chip 23 is a surface on the +Z direction side. The LED chips 23 are arrayed in a row along the Y direction. For example, the LED chips 23 that emit white light and the LED chips 23 that emit light of a light bulb color are alternately arranged.

The mirror surface mirror member 24 is arranged on the +Z direction side of the substrate 22. The mirror surface mirror member 24 is configured by a tabular portion 24a, a principal plane of which is the XY plane, and a triangular prism portion 24b integrally coupled to an end on the +X direction side of the tabular portion 24a. A surface facing the +Z direction of the tabular portion 24a and a surface facing the +Z direction of the triangular prism portion 24b configure a continuous XY plane. Three side surfaces of the triangular prism portion 24b are a surface facing the +Z direction, a surface facing the -X direction, and a surface faxing a +X-Z direction. The surface facing the +X-Z direction is a mirror surface 24c that is opposed to the LED chips 23 and reflects incident lights. For example, aluminum is vapor-deposited on the mirror surface 24c. The mirror surface 24c is a concave curved surface and is, for example, a parabolic cylindrical surface having a focal point at one point in the light-emitting surfaces 23a of the LED chips 23.

The triangular prism portion 24b of the mirror surface mirror member 24 is arranged to cover the LED chips 23. That is, the triangular portion 24b is arranged in the +Z direction and the -X direction when viewed from the LED chips 23. Therefore, when the light-emitting device 10 is viewed from the +Z direction side, the LED chips 23 are hidden by the mirror surface mirror member 24. On the other hand, the mirror surface mirror member 24 is not arranged in the +X direction and the Y direction when viewed from the LED chips 23. The +X direction and the +Y direction of the mirror surface mirror member 24 is opened.

The prism plate 25 is arranged on the +Z direction side when viewed from the white mirror plate 21, the substrate 22, the LED chips 23, and the mirror surface mirror member 24. Screw holes 25a are formed at an end on the -X direction side of the prism plate 25. The prism plate 25 is screwed to the mirror surface mirror member 24 via the screw holes 25a. On the other hand, an end on the +X direction side of the prism plate 25 is in contact with an end in the +X direction side of the white mirror plate 21.

A surface on the -Z direction side (an upper surface) of the prism plate 25 is a light incident surface 25b on which lights emitted from the LED chips 23 are irradiated. A plurality of triangular prisms are cyclically formed on the light incident surface 25b. The triangular prisms extend in the Y direction and formed by a slope 25c facing a -X-Z direction and a slope 25d facing the +X-Z direction. An inclination angle of the slope 25c with respect to the XY plane is larger than an inclination angle of the slope 25d. The width of the slope 25c is smaller than the width of the slope 25d. On the other hand, a surface on the +Z direction side (a lower surface) of the prism plate 25 is a light emission surface 25e from which light is emitted. The light emission surface 25e is parallel to the XY plane.

A hollow 26 is marked off by the white surface 21a of the white mirror plate 21, a portion on the +X direction side of the chip mounting surface 22a of the substrate 22, the mirror surface 24c of the mirror surface mirror member 24, and the light incident surface 25b of the prism plate 25. The LED chips 23 are arranged on the inside of the hollow 26.

The operation of the luminaire 1 according to this embodiment is explained.

Figs. 8A to 8C are diagrams illustrating the operation of the luminaire according to this embodiment.

When a switch of the luminaire 1 is turned on, a 100V alternating current is supplied to the power supply unit 14 via the socket 16. The power supply unit 14 converts the 100V alternating current into a direct current of a predetermined voltage and supplies the direct current to the control unit 12 via the wire 15. The control unit 12 supplies electric power to the LED chips 23 via the substrate 22 and controls the LED chips 23. Consequently, the light-emitting surfaces 23a of the LED chips 23 emit lights.

As shown in Fig. 8A, among the lights emitted from the LED chips 23, lights L1 emitted in the +X direction side are irradiated on the light incident surface 25b of the prism plate 25 and made incident in the prism plate 25 mainly via the slope 25c. At this point, since the slope 25c faces the -X-Z direction side, an angle of incidence of the lights L1 emitted from the LED chips 23 is small. The lights L1 are rarely reflected on the slope 25c. The lights L1 are propagated in the prism plate 25 and emitted to the outside of the luminaire 1 from the light emission surface 25e. At this point, on the prism plate 25, since a portion further on the -X direction side is closer to the LED chips 23, an amount of the lights L1 made incident on the light incident surface 25b is larger. Therefore, an amount of the lights L1 emitted from the light emission surface 25e is also larger.

As shown in Figs. 8B and 8C, among the lights emitted from the LED chips 23, lights L2 emitted to the -X direction side are irradiated on the mirror surface 24c of the mirror surface mirror member 24. Since the mirror surface 24c is a concave curved surface facing the +X-Z direction, the lights L2 travel to the +X direction side by being reflected by the mirror surface 24c and traveling directions of the lights L2 are aligned. In particular, when the mirror surface 24c is a parabolic cylindrical surface and the light-emitting surfaces 23a of the LED chips 23 are located near a focal point of the mirror surface 24c, an effect of aligning the traveling directions of the lights L2 is high. In actual LED chips 23, lights are emitted from the entire light-emitting surfaces and orientation characteristics of the lights are different depending on a product. However, a fixed effect can be obtained by forming the mirror surface 24c in a shape close to the parabolic cylindrical surface.

The white surface 21a of the white mirror plate 21 is displaced further to the +Z direction toward the +X direction. Therefore, the lights L2 reflected by the mirror surface 24c are extended in the X direction and irradiated on the white surface 21a. The lights L2 are reflected and diffused by the white surface 21a, travel to the +Z direction side, and are emitted to the outside of the luminaire 1 via the prism plate 25. In this way, the white mirror plate 21 is an optical member that guides the lights L2, which are emitted from the LED chips 23 and reflected by the mirror surface mirror member 24, to the +Z direction.

If the lights L2 reflected by the mirror surface 24c are uniform parallel lights, as shown in Fig. 8B, the lights are uniformly irradiated on the white surface 21a if the white surface 21a is a flat inclined surface. On the other hand, as shown in Fig. 8C, if the white surface 21a is a concave curved surface, since an inclination angle with respect to the XY plane is larger in a portion further on the +X direction side, an amount of the irradiated lights L2 is larger. Therefore, an amount of the reflected lights L2 is larger. In this case, it is possible to supplement an intensity distribution of the lights L1 shown in Fig. 8A, that is, an intensity distribution in which intensity on the -X direction side is higher and uniformize the total intensity of the lights L1 and the lights L2 emitted from the light-emitting device 10.

In this way, light are substantially uniformly emitted from the light emission surface 25e of the prism plate 25 of the light-emitting device 10 at a wide angle. Consequently, in the entire luminaire 1, lights are substantially uniformly emitted from light-emitting regions in two places corresponding to the prism plates 25 of the two light-emitting devices 10. On the other hand, a region corresponding to the cover 13 is a non-light-emitting region.

The LED chips 23 are mounted on the substrate 22. A surface on the -Z direction side of the substrate 22 is in contact with the surface on the +Z direction side of the white mirror plate 21. A surface of the -Z direction side of the white mirror plate 21 is in contact with the chassis 11. Consequently, heat generated in the LED chips 23 is transmitted to the chassis 11 by heat conduction via the substrate 22 and the white mirror plate 21 and emitted to the outside of the luminaire 1.

Effects of this embodiment are explained below.

In the luminaire 1 according to this embodiment, the mirror surface mirror member 24 is arranged in the +Z direction when viewed from the LED chips 23. Therefore, when the luminaire 1 is viewed from the +Z direction, the LED chips 23 are hidden by the mirror surface mirror member 24 and are not directly visually recognized. Consequently, lights emitted from the LED chips 23 do not directly reach the eyes of a user. It is possible to reduce glare felt by the user.

In this embodiment, the lights emitted from the LED chips 23 are reflected toward the +X direction by the mirror surface mirror member 24 and irradiated on a region extending in the X direction on the white surface 21a of the white mirror plate 21. The irradiated lights are reflected toward the +Z direction at respective points of the white surface 21a. Consequently, it is possible to emit the lights emitted from the LED chips 23 toward the +Z direction after extending the lights in the X direction. As a result, it is possible to increase a light-emitting area and reduce brightness compared with a light-emitting area and brightness obtained when the LED chips 23 are used as they are. This also makes it possible to reduce glare.

Further, in this embodiment, the plurality of LED chips 23 are arrayed along the Y direction. Therefore, it is possible to realize a surface light source expanding in the X direction and the Y direction in conjunction with the effect of extending the lights emitted from the LED chips 23 in the X direction.

Furthermore, in this embodiment, since the surface (the mirror surface 24c) on which lights are irradiated in the mirror surface mirror member 24 is a mirror surface, it is possible to efficiently reflect the lights emitted from the LED chips 23 toward the +X direction. Since the surface (the white surface 21a) on which lights are irradiated in the white mirror plate 21 is a white surface that reflects and diffuses the lights, it is possible to diffuse the lights emitted from the LED chips 23 and reflected by the mirror surface mirror member 24 at the respective points of the white surface 21a. Consequently, it is possible to obtain a uniform light-emitting surface. This also makes it possible to reduce glare.

In this embodiment, lights are diffused by the white mirror plate 21. Therefore, it is unnecessary to provide a transmitting and diffusing plate in order to diffuse the lights and reduce glare. It is necessary to increase the thickness of the transmitting and diffusing plate in order to sufficiently diffuse the lights with the transmitting and diffusing plate. Then, the thickness of the light-emitting device increases and utilization efficiency of the lights falls. In this embodiment, since it is unnecessary to provide the transmitting and diffusing plate, it is possible to attain a reduction in thickness and improvement of efficiency of the light-emitting device 10. If the utilization efficiency of the lights is high, the number of the LED chips 23 and an output of the LED chips 23 can be reduced. Therefore, it is possible to reduce costs and power consumption of the light-emitting device.

Further, in this embodiment, the mirror surface 24c of the mirror surface mirror member 24 is the parabolic cylindrical surface and one point of the light-emitting surfaces 23a of the LED chips 23 is located at the focal point of the mirror surface 24c. Therefore, it is possible to efficiently convert lights emitted from the LED chips 23 into parallel lights. Since the white surface 21a of the white mirror plate 21 is the concave curved surface, it is possible to reflect more lights in a region on the +X direction side. Consequently, it is possible to supplement non-uniformity in that lights directly made incident on the prism plate 25 from the LED chips 23 are emitted from a region on the -X direction side more and uniformly emit the lights from the light-emitting device 10 as a whole.

Furthermore, in this embodiment, a prism is formed on the light incident surface 25b of the prism plate 25. Therefore, the slope 25c having a small angle of incidence when the lights emitted from the LED chips 23 are made incident thereon is present on the light incident surface 25b. Consequently, it is possible to efficiently guide the lights into the prismplate 25. As a result, the utilization efficiency of the lights is improved.

Furthermore, in the luminaire 1 according to this embodiment, a principal plane (a surface on the +Z direction side) of the chassis 11 is in contact with one principal plane (a surface on the -Z direction side) of the white mirror plate 21. The other principal plane (a surface on the +Z direction side) of the white mirror plate 21 is in contact with a principal plane (a surface on the -Z direction side) of the substrate 22. Consequently, it is possible to efficiently transmit heat generated in the LED chips 23 to the chassis 11 through heat conduction. As a result, the luminaire 1 has a high thermal radiation property.

Since the chassis 11 is provided to house the light-emitting device 10, it is possible to improve the rigidity of a portion of the luminaire 1 housed in the chassis 11. If the chassis 11 is formed of metal, it is possible to further improve the thermal radiation property and the rigidity. On the other hand, if the chassis 11 is formed of resin excellent in heat conductivity, it is possible to attain a reduction in weight of the chassis 11 while securing the thermal radiation property. Consequently, it is possible to suppress deformation of the chassis 11 due to the own weight thereof.

Furthermore, in the luminaire 11 according to this embodiment, the common control unit 12 is provided in the two light-emitting devices 10. Consequently, it is possible to reduce the number of control units 12 and use the power supply unit 14, the socket 15, and the wire 16 in common. Therefore, it is possible to greatly reduce the number of components. When the luminaire 1 is attached to the ceiling or the like, the size of a portion set in the attic can be reduced and the number of components to be attached is reduced. Therefore, work for attaching the luminaire 1 is simplified. As a result, it is possible to reduce manufacturing costs of the luminaire 11 and reduce attachment costs of the luminaire 1.

Since the control unit 12 is arranged in the non-light-emitting region of the light-emitting device 10, it is possible to integrate the control unit 12 with the chassis 11 without blocking the light-emitting region of the light-emitting device 10. Consequently, it is easy to supply electric power to the light-emitting devices 10. Further, it is unnecessary to arrange the control unit 12 on the outside of the chassis 11. As a result, for example, when the luminaire 1 is attached to the ceiling, it is unnecessary to fix the control unit 12 in the attic and work for attaching the luminaire 1 is simplified.

A test example in this embodiment is explained.

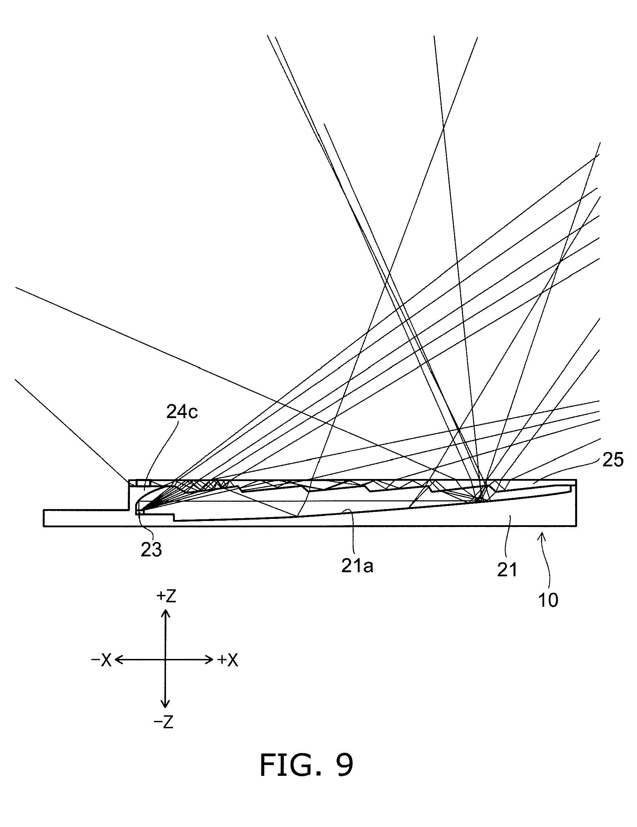

Fig. 9 is a diagram showing a simulation result of the test example.

As shown in Fig. 9, in this test example, tracks of lights emitted from the LED chips 23 were simulated concerning the luminaire 10 according to this embodiment. However, lights reflected by the mirror surface 24c were represented as one beam traveling to the +X direction. Diffusing and reflecting behavior at one point of the white surface 21a was simulated.

As a result, most part of lights directly made incident on the prism plate 25 from the LED chips 23 were emitted generally toward a +X+Z direction from the prism plate 25. Lights emitted from the LED chips 23, reflected on the mirror surface 24c, and diffused and reflected on the white surface 21a were emitted at a wide angle via the prism plate 25. Actually, taking into account the fact that the lights are irradiated on the entire region of the white plate 21a, the lights are considered to be substantially uniformly emitted toward all the directions on the +Z direction side from the light-emitting device 10.

In the example explained in this embodiment, the prism plate 25 is provided in the light-emitting device 10. However, the prism plate 25 does not always have to be provided. A transparent flat plate or a thin diffuser may be provided instead of the prism plate 25.

Further, the substrate 22 and the mirror surface mirror member 24 may be integrated as one component.

A first modification of the first embodiment is explained.

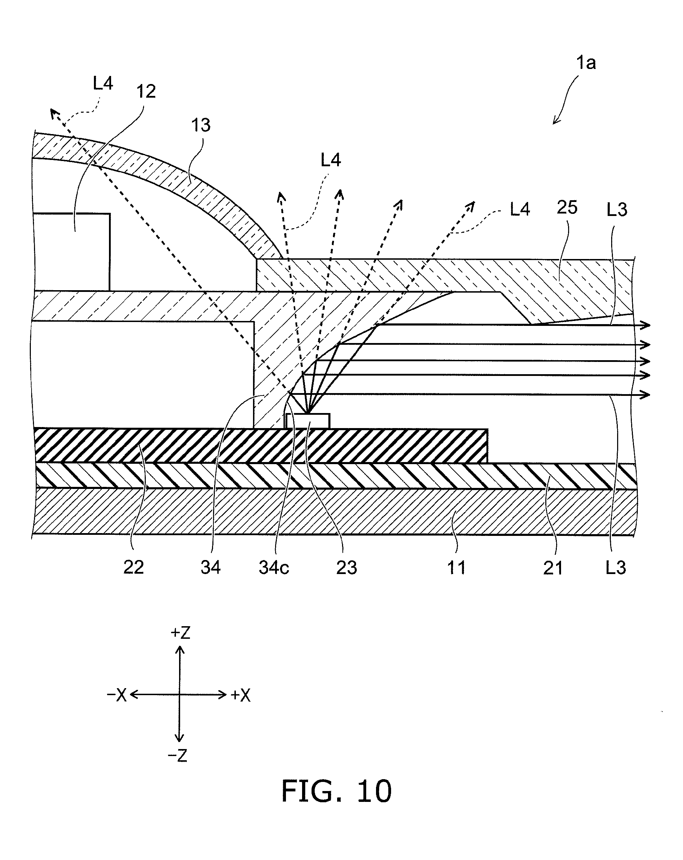

Fig. 10 is a partially enlarged sectional view illustrating a luminaire according to this modification.

As shown in Fig. 10, a luminaire 1a according to this modification is different from the luminaire 1 (see Fig. 4) according to the first embodiment in that a mirror surface mirror member 34 is formed of a transparent material and a mirror surface 34c is a half mirror. Consequently, among lights emitted from the LED chips 23 and reaching the mirror surface 34c, most lights L3 are reflected toward the -X direction by the mirror surface 34c. However, a part of lights L4 are transmitted through the mirror surface mirror member 34 via the mirror surface 34c and emitted toward the outside of the luminaire 1a. If the cover 13 is formed of a transparent or semitransparent material, even lights transmitted through the mirror surface mirror member 34 and the cover 13 are emitted from the luminaire 1a.

According to this modification, since lights are emitted from a part of the mirror surface mirror member 34 besides the prism plate 25, a light-emitting region is wide when viewed from the +Z direction. Consequently, brightness falls and glare is further reduced. Components, operations, and effects in this modification other than those explained above are the same as those in the first embodiment.

A second modification of the first embodiment is explained.

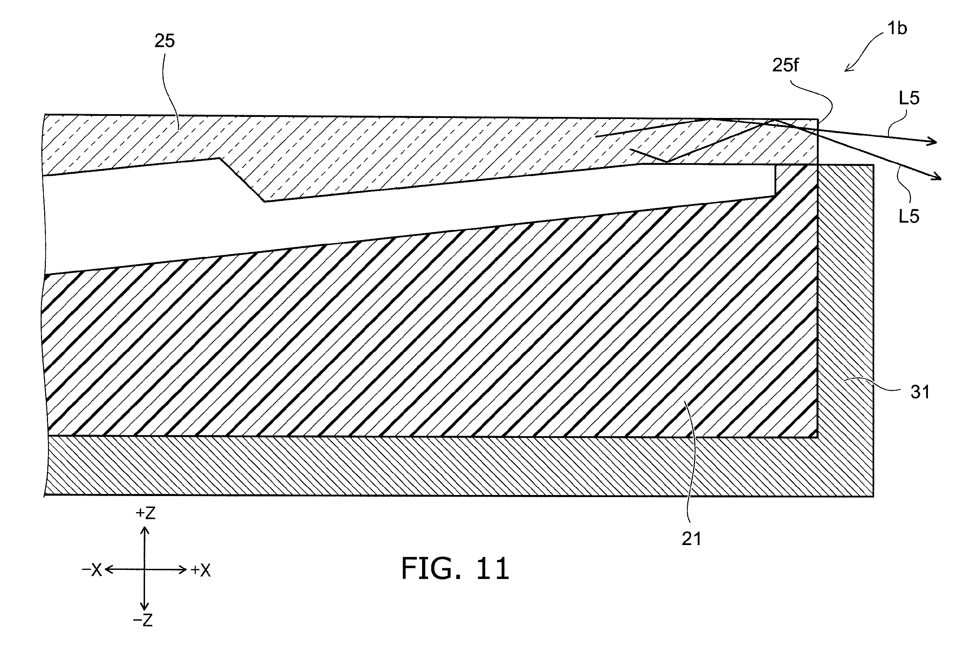

Fig. 11 is a partially enlarged sectional view illustrating a luminaire according to this modification.

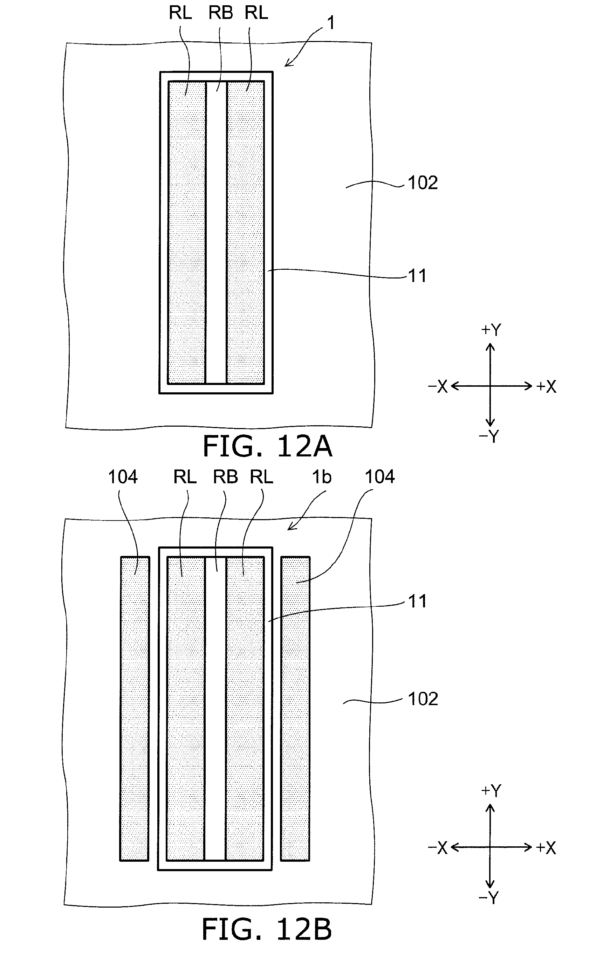

Figs. 12A and 12B are schematic diagrams illustrating the luminaire attached to the ceiling. Fig. 12A shows the first embodiment and Fig. 12B shows this modification.

In Figs. 12A and 12B, a light-emitting region is indicated by light gray.

As shown in Fig. 11, a luminaire 1b according to this modification is different from the luminaire 1 (see Fig. 4) according to the first embodiment in that the height of a side surface portion on the X-direction side of a chassis 31 is lowered and a side surface on a far side from the LED chips 23 in the prism plate 25 is exposed to the outside of the luminaire 1b. Consequently, a part of lights L5 propagated in the prism plate 25 are emitted to the outside of the luminaire 1b from the side surface on the far side from the LED chips 23 in the prism plate 25, for example, a side surface 25f on the +X direction side in the prism plate 25 shown in Fig. 11.

As shown in Fig. 12A, when the luminaire 1 according to the first embodiment is attached to the ceiling 102, regions corresponding to the prism plates 25 of the light-emitting devices 10 are light-emitting regions RL and a region corresponding to the mirror surface mirror member 21, the cover 13, and the like is a non-light-emitting region RB. In this way, in the entire luminaire 1, the non-light-emitting region RB is arranged in the center in the X direction and the light-emitting regions RL are arranged at both ends in the X direction.

On the other hand, as shown in Fig. 12B, when the luminaire 1b according to this modification is attached to the ceiling 102, lights emitted from the side surface 25f are irradiated on regions 104 in two places on the X-direction side when viewed from the luminaire 1b on the ceiling 102. The regions 104 are brightened. Consequently, besides the light-emitting regions RL, the regions 104 function as indirect light-emitting regions. As a result, an apparent light-emitting area increases and glare can be further reduced. Components, operations, and effects other than those explained above in this modification are the same as those in the first embodiment.

A second embodiment is explained.

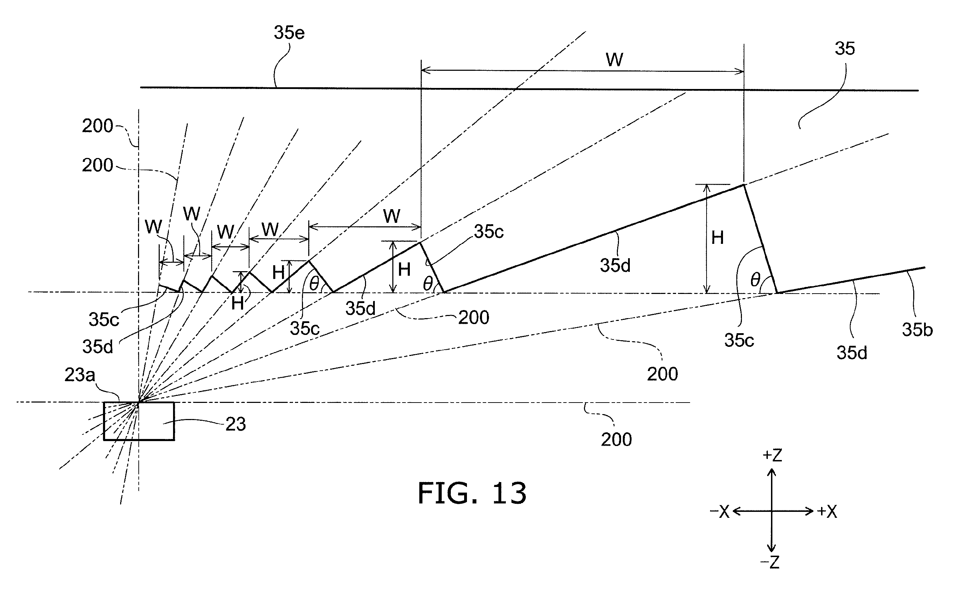

Fig. 13 is a schematic sectional view illustrating a light-emitting device according to this embodiment.

Auxiliary lines 200 shown in Fig. 13 are straight lines parallel to an XZ plane and radially extending from one point of the light-emitting surface 23a of the LED chip 23.

As shown in Fig. 13, the light-emitting device according to this embodiment is different from the light-emitting device 10 (see Fig. 4) according to the first embodiment in the shape of a prism plate 35.

In the prism plate 35, as in the prism plate 25 (see Fig. 7) in the first embodiment, a plurality of triangular prisms are formed on a light incident surface 35b. The triangular prisms extend in the Y direction. The triangular prisms are configured from slopes 35c facing the LED chip 23 side and slopes 35d facing the opposite side of the LED chip 23.

However, in the prism plate 35, unlike the prism plate 25, a width W is larger in a prism farther from the LED chip 23, that is, in the example shown in Fig. 13, in a prism located further on the +X direction side. The width W is the total length of the slopes 35c and 35d in the X direction. In the prism plate 35, a formation height H is larger in a prism farther from the LED chip 23. The formation height H is the length of the slope 35c in the Z direction. Further, in the prism plate 35, an inclination angle θ of the slope 35c on the LED chip 23 side is larger in the prism farther from the LED chip 23. The inclination angle θ is an angle formed by the slope 35c and the XY plane.

As shown in Fig. 13, in this embodiment, incident angles at which lights radially emitted from the LED chip 23 are made incident on a plurality of the slopes 35c of the prism plate 35 can be set small in all the slopes 35c. Consequently, the lights emitted from the LED chip 23 are efficiently guided into the prism plate 35. Utilization efficiency of the lights can be improved. Components, operations, and effects other than those explained above in this embodiment are the same as those in the first embodiment.

A third embodiment is explained.

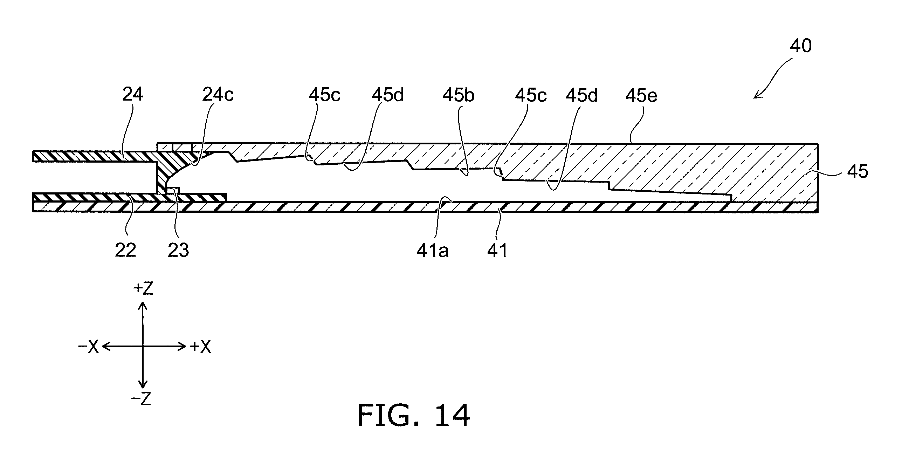

Fig. 14 is a sectional view illustrating a light-emitting device according to this embodiment.

As shown in Fig. 14, a light-emitting device 40 according to this embodiment is different from the light-emitting device 10 (see Fig. 4) according to the first embodiment in that a white surface 41a of a white mirror plate 41 is parallel to the XY plane and, instead, an end on a far side from the LED chip 23 is located further on the -Z direction side than an end on a near side to the LED chip 23 on a surface on the -Z direction side of a prism plate 45, that is, a light incident surface 45b.

That is, in the example shown in Fig. 14, the light incident surface 45b is displaced further to the -Z direction as a whole toward the +X direction. However, since a prism formed by slopes 45c and 45d is formed on the light incident surface 45b, the slope 45d is sometimes displaced further to the +Z direction toward the +X direction. An end on the +X direction side in the prism plate 45 is in contact with the white mirror plate 41. On the other hand, a light emission surface 45e facing the +Z direction in the prism plate 45 is parallel to the XY plane.

In the light-emitting device 40, a part of lights emitted from the LED chip 23 is directly made incident on the light incident surface 45b of the prism plate 45. Lights emitted from the LED chip 23 and reflected toward the +X direction by the mirror surface 24c of the mirror surface mirror member 24 are also mainly made incident on the light incident surface 45b of the prism late 45. The lights made incident on the light incident surface 45b are propagated in the prism plate 45 and emitted from the light emission surface 45e. That is, in the light-emitting device 40, rather than the white mirror plate 41, the prism plate 45 functions as an optical member that guides the lights emitted from the LED chip 23 and reflected by the mirror surface mirror member 24 to the +Z direction. The lights reflected on the light incident surface 45b of the prism plate 45 and the lights internally reflected by the light emission surface 45e and emitted toward the -Z direction from the light incident surface 45b are diffused and reflected by the white surface 41a of the white mirror plate 41 and made incident on the prism plate 45 again.

In this embodiment, most of the lights output from the LED chip 23 are captured by the prism plate 45 directly or via the mirror surface mirror member 24 and emitted to the +Z direction side. In this way, in this embodiment, since the white surface 41a is not interposed in a main route of the lights, utilization efficiency of the lights is high. Components, operations, and effects other than those explained above in this embodiment are the same as those in the first embodiment.

A modification of the third embodiment is explained.

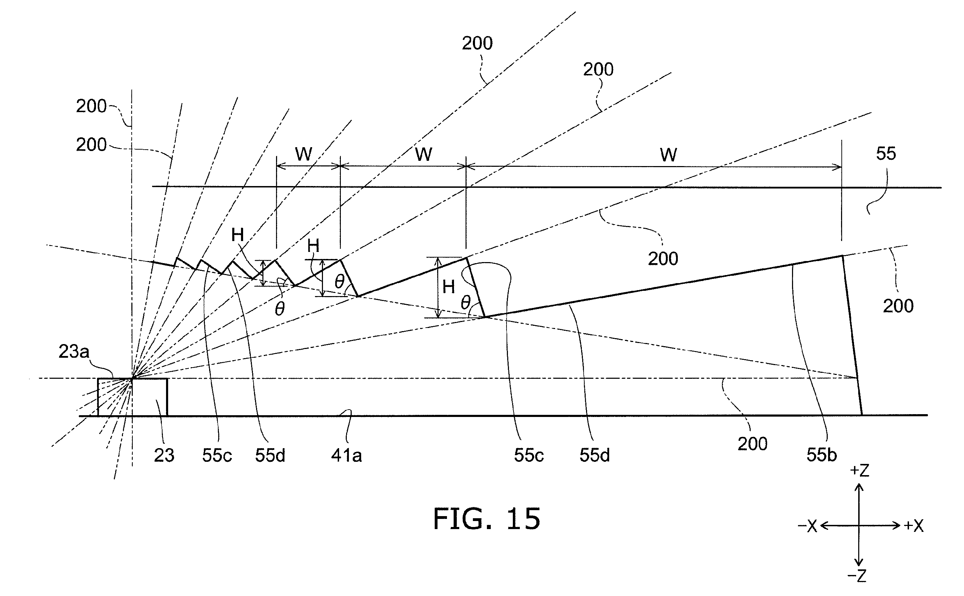

Fig. 15 is a schematic sectional view illustrating a light-emitting device according to this modification.

This modification is an example in which the second embodiment and the third embodiment are combined.

That is, as shown in Fig. 15, in the light-emitting device according to this modification, as in the third embodiment, the white mirror plate 41, the white surface 41a of which is parallel to the XY plane, and a prism plate 55, an end on the +X direction side of which on a light incident surface 55b is located further on the -Z direction side than an end on the -X direction side thereof, are provided. As in the second embodiment, in the prism plate 55, in a prism farther from the LED chip 23, the width W is larger, the formation height H is larger, and the inclination angle θ of a slope 55c on the LED chip 23 side is larger.

According to this modification, in a light-emitting device of a type for capturing most of lights reflected by the mirror surface mirror member 24 with the prism plate 55, it is possible to also improve incident efficiency of lights directly made incident on the prism plate 55 from the LED chip 23. Consequently, it is possible to further improve the utilization efficiency of the lights. Components, operations, and effects in this modification other than those explained above are the same as those in the third embodiment.

In the third embodiment and this modification, as in the second modification (see Fig. 11) of the first embodiment, a side surface on a far side from the LED chip 23 in the prism plate may be exposed to emit lights from the side surface. Consequently, it is possible to obtain effects same as the effects shown in Fig. 12B.

A fourth embodiment is explained.

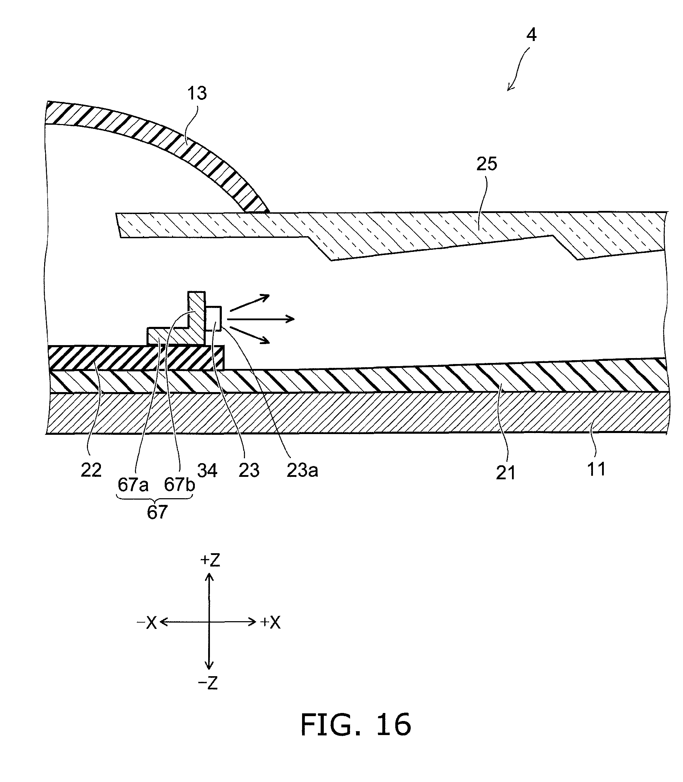

Fig. 16 is a partial sectional view illustrating a luminaire according to this embodiment.

As shown in Fig. 16, in a luminaire 4 according to this embodiment, an L-shape angle 67 is provided on a surface on the +Z direction side of the substrate 22. The L-shaped angle 67 is a member, an XZ section of which is an L shape, extending in the Y direction. The L-shaped angle 67 is configured from a tabular portion 67a parallel to the XY plane and a tabular portion 67b parallel to the YZ plane. The tabular portion 67a is attached to the chip mounting surface 22a of the substrate 22. The tabular portion 67b is erected from the chip mounting surface 22a. The LED chip 23 is mounted on a surface on the +X direction side of the tabular portion 67b. Therefore, the light-emitting surface 23a of the LED chip 23 crosses the chip mounting surface 22a of the substrate 22, more specifically, faces the +X direction. In the luminaire 4, the mirror surface mirror member 24 (see Fig. 4) is not provided. An end of the cover 13 is arranged in a position in the +Z direction when viewed from the LED chip 23. The cover 13 is formed of a nontransparent material.

In this embodiment, the LED chip 23 is attached to the substrate 22 via the L-shaped angle 67. Therefore, the light-emitting surface 23a of the LED chip 23 faces the +X direction and emits lights mainly toward the +X direction. Therefore, the mirror surface mirror member 24 is unnecessary.

In this embodiment, the end of the nontransparent cover 13 is arranged in the position corresponding to the +Z direction when viewed from the LED chip 23. Therefore, when viewed from the +Z direction side, the LED chip 23 is hidden by the cover 13. Therefore, lights leaking in the +Z direction from the LED chip 23 are blocked by the cover 13 and are not directly made incident on the eyes of a user. Consequently, it is possible to reduce glare. Components, operations, and effects other than those explained above in this embodiment are the same as those in the first embodiment. The cover 13 may be formed of a semitransparent material.

A fifth embodiment is explained.

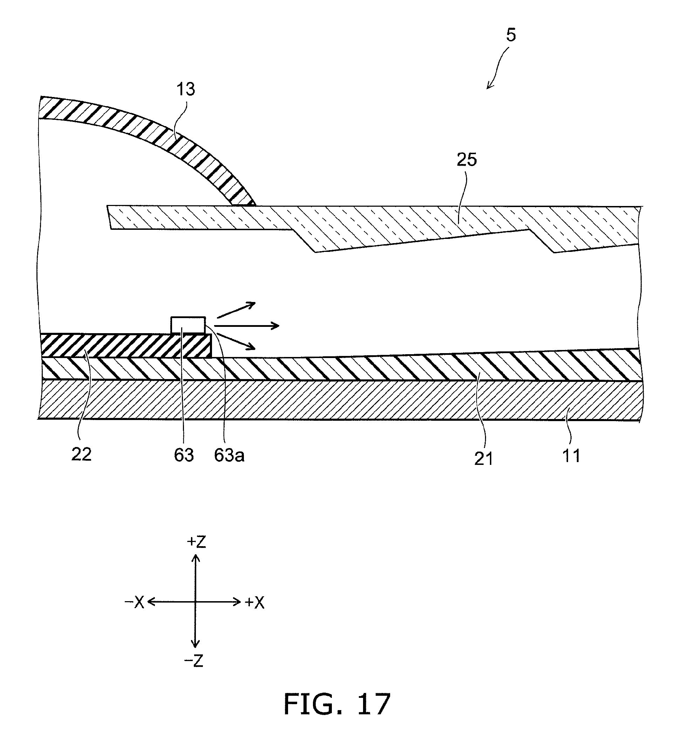

Fig. 17 is a partial sectional view illustrating a luminaire according to this embodiment.

As shown in Fig. 17, a luminaire 5 according to this embodiment is different from the luminaire 1 (see Fig. 4) according to the first embodiment in that an LED chip 63 of a side view type is provided instead of the LED chip 23 of the top view type. In the LED chip 63 of the side view type, lights are emitted from a surface orthogonal to a mounting surface (a surface on the -Z direction side). In the example shown in Fig. 17, the LED chip 63 is arranged on the substrate 22 such that a light-emitting surface 63a thereof faces the +X direction.

As in the fourth embodiment, in the luminaire 5, the mirror surface mirror member 24 (see Fig. 4) is not provided. Further, an end of the cover 13 is arranged in a position in the +Z direction when viewed from the LED chip 63. The cover 13 is formed of a nontransparent material.

In this embodiment, as in the fourth embodiment, the LED chip 63 emits lights mainly toward the +X direction. Therefore, the mirror surface mirror member 24 is unnecessary. An end of the cover 13 is arranged in a position corresponding to the +Z direction when viewed from the LED chip 63. Therefore, when viewed from the +Z direction side, the LED chip 63 is hidden by the cover 13. Further, in this embodiment, compared with the fourth embodiment, the L-shaped angle 67 (see Fig. 16) is unnecessary. Components, operations, and effects other than those explained above in this embodiment are the same as those in the fourth embodiment.

In the fourth and fifth embodiments, a supporting member for fixing the prism plate 25 may be provided. When the supporting member is provided, the control unit 12 (see Fig. 1) may be fixed to the supporting member. A surface opposed to the LED chip 23 in the supporting member may be a mirror surface, may be a white surface, or may be other surfaces. The prism plate 25 may be able to be fixed to the white mirror plate 21 or the substrate 22 by, for example, contriving the shape of the end on the -X direction side of the prism plate 25 without providing the supporting member. Furthermore, a component for hiding an LED chip is not limited to the cover 13. A part of some other component may be arranged in the +Z direction when viewed from the LED chip.

A sixth embodiment is explained.

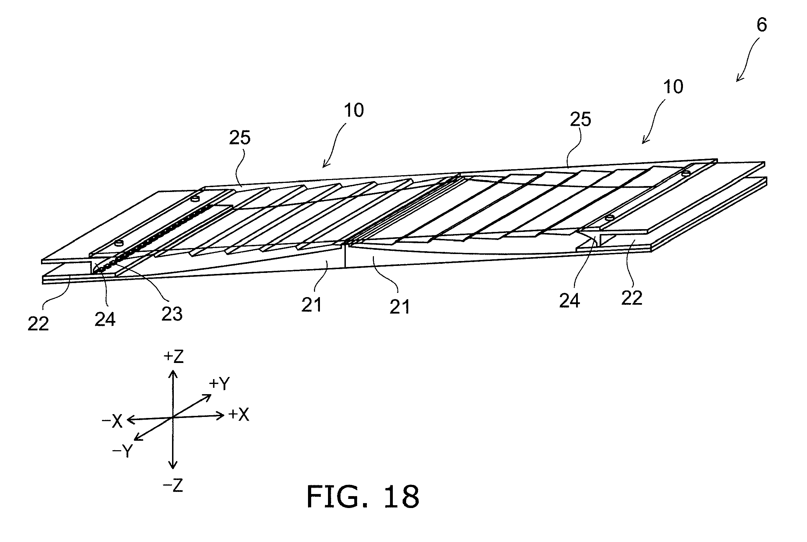

Fig. 18 is a perspective view illustrating a luminaire according to this embodiment.

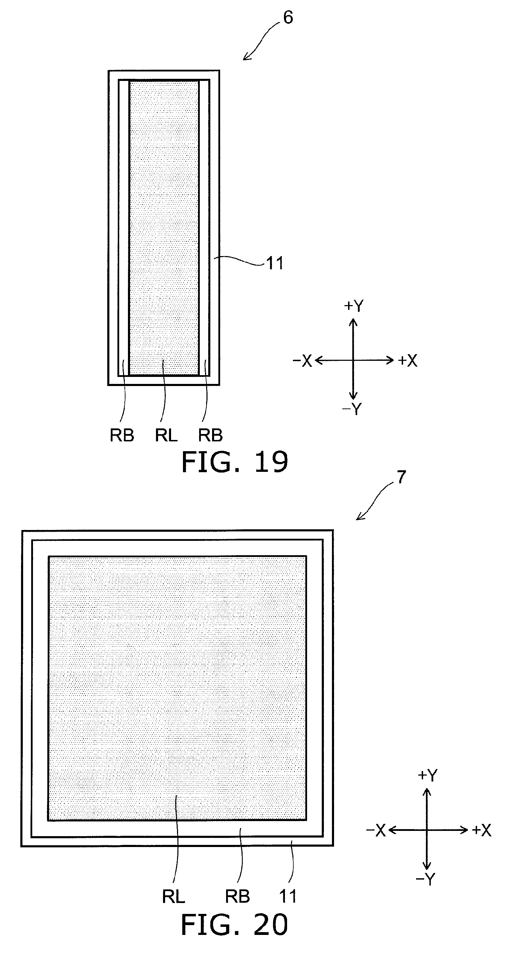

Fig. 19 is a schematic plan view illustrating the luminaire according to this embodiment.

In Fig. 18, for convenience of illustration, only the two light-emitting devices 10 are shown. A chassis, a control unit, a cover, and the like are not shown.

As shown in Fig. 18, a luminaire 6 according to this embodiment is different from the luminaire 1 (Fig. 6) according to the first embodiment in an arrangement of the light-emitting devices 10. The number of the light-emitting devices 10 and the configuration of the light-emitting devices 10 are the same as those in the first embodiment.

That is, in the luminaire 6, as in the luminaire 1, the two light-emitting devices 10 are provided. However, unlike the luminaire 1, ends on sides where the LED chips 23 and the mirror surface mirror members 24 are not arranged in the light-emitting devices 10 are connected.

Consequently, as shown in Fig. 19, in the entire luminaire 6, the non-light-emitting regions RB are arranged at both ends in the X direction and a light-emitting region RL is arranged in the center in the X direction. As a result, it is possible to form one wide light-emitting region RL. Components, operations, and effects other than those explained above in this embodiment are the same as those in the first embodiment.

A seventh embodiment is explained.

Fig. 20 is a schematic plan view illustrating a luminaire according to this embodiment.

In a luminaire 7 according to this embodiment, four sets of light source structures including the substrate 22, the plurality of LED chips 23 mounted on the substrate 22, and the mirror surface mirror member 24 shown in Fig. 7 are provided. The light source structures are connected in a rectangular frame shape. A white mirror plate and a prism plate are provided in a rectangular region surrounded by the four sets of light source structures.

Consequently, as shown in Fig. 20, in the luminaire 7, the light-emitting region RL having a rectangular shape is provided in one place. The non-light-emitting region RB having a frame shape is provided around the light-emitting region RL.

According to this embodiment, as in the sixth embodiment, it is possible to form one wide light-emitting region. Components, operations, and effects other than those explained above in this embodiment are the same as those in the first embodiment.

According to the embodiments explained above, it is possible to realize a light-emitting device and a luminaire that can reduce glare.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments described herein may be made without departing from the spirit of the inventions. The embodiments and the modifications thereof are included in the scope and the spirit of the invention and included in the scope of the inventions described in the accompanying claims and their equivalents. The embodiments can be carried out in combination with one another.

## Claims

1. A light-emitting device comprising:
a substrate;
an LED chip mounted on a lower surface of the substrate;
a light reflecting member arranged downward and on one side when viewed from the LED chip and opened on the other side, a surface of the light reflecting member opposed to the LED chip being a light reflecting surface; and
an optical member configured to guide light emitted from the LED chip and reflected by the light reflecting member downward.

2. The light-emitting device according to claim 1, wherein the optical member includes a light diffusing and reflecting plate, a lower surface of which is a light diffusing and reflecting surface, and
a part of the light reflected by the light reflecting member is irradiated on the lower surface of the light diffusing and reflecting plate.

3. The light-emitting device according to claim 2, wherein an end on the other side on the lower surface of the light diffusing and reflecting plate is located below an end on the one side on the lower surface.

4. The light-emitting device according to claim 3, wherein the lower surface of the light diffusing and reflecting plate is a concave curved surface.

5. The light-emitting device according to claim 2, wherein the lower surface of the light diffusing and reflecting plate is a white surface.

6. The light-emitting device according to claim 2, further comprising a prism plate, on an upper surface of which a plurality of prisms are formed, wherein
among lights emitted from the LED chip, a part of lights not irradiated on the light reflecting member are irradiated on the upper surface.

7. The light-emitting device according to claim 1, wherein the optical member includes a prism plate, an end on the other side on an upper surface of which is located above an end on the one side thereof, and
the light reflected by the light reflecting member is irradiated on the upper surface of the prism plate.

8. The light-emitting device according to claim 1, wherein the light reflecting surface of the light reflecting member is a mirror surface.

9. The light-emitting device according to claim 1, wherein the light reflecting surface of the light reflecting member is a parabolic cylindrical surface.

10. The light-emitting device according to claim 1, wherein
a shape of the substrate is a belt shape extending in a direction crossing both of a direction from the one side to the other side and an up down direction, and
a plurality of the LED chips are arrayed along the crossing direction.

11. A luminaire comprising:
a light-emitting device; and
a chassis configured to cover an upper surface of the light-emitting device, wherein
the light-emitting device includes:
a substrate;
an LED chip mounted on a lower surface of the substrate; and
a light reflecting member arranged downward and on one side when viewed from the LED chip and opened on the other side, a surface of the light reflecting member opposed to the LED chip being a light reflecting surface, and
heat of the LED chip is transmitted to the chassis by heat conduction.

12. The luminaire according to claim 11, wherein
a shape of the substrate is a belt shape extending in a direction crossing both of a direction from the one side to the other side and an up down direction, and
a plurality of the LED chips are arrayed along the crossing direction.

13. The luminaire according to claim 11, wherein
a shape of the chassis is a tray shape, and
the light-emitting device is arranged on an inside of the chassis.

14. The luminaire according to claim 13, further comprising:
a control unit configured to control the light-emitting device; and
a power supply unit arranged on an outside of the chassis and configured to supply electric power to the control unit.

15. The luminaire according to claim 14, wherein the control unit is arranged below the light reflecting member.

16. The luminaire according to claim 14, wherein
a plurality of the light-emitting devices are provided, and
the control unit is provided in common to the plurality of light-emitting devices.

17. The luminaire according to claim 11, wherein the light-emitting device further includes an optical member configured to guide light emitted from the LED chip and reflected by the light reflecting member downward.

18. The luminaire according to claim 17, wherein
the optical member includes a light diffusing and reflecting plate, a lower surface of which is a light diffusing and reflecting surface,
the light reflected by the light reflecting member is irradiated on the lower surface of the light diffusing and reflecting plate,
the substrate is in contact with the light diffusing and reflecting plate, and
the light diffusing and reflecting plate is in contact with the chassis.

19. The luminaire according to claim 11, wherein the chassis is formed of metal.

20. The luminaire according to claim 17, wherein
the optical member includes a prism plate, on an upper surface of which a plurality of prisms are formed,
among lights emitted from the LED chip, a part of lights not irradiated on the light reflecting member are irradiated on the upper surface of the prism plate, and
a side surface on the other side in the prism plate is not covered with the chassis and is exposed to an outside.
